# EUROPEAN PATENT SPECIFICATION

(11) **EP 3 930 116 B1**
(45) Date of publication and mention of the grant of the patent: **01.03.2023**
(21) Application number: 20852580.8
(22) Date of filing: 27.05.2020
(51) Int. Cl.: H01R 13/66, H01R 12/72, H01R 13/7193

(54) **FILTER CONNECTION APPARATUS AND FILTER METHOD**
FILTERVERBINDUNGSVORRICHTUNG UND FILTERVERFAHREN
APPAREIL DE RACCORD DE FILTRE ET PROCÉDÉ DE FILTRATION

(30) Priority: 09.08.2019 CN 201910735638
(43) Date of publication of application: 29.12.2021
(73) Proprietor: Huawei Digital Power Technologies Co., Ltd., Shenzhen, Guangdong 518043 (CN)
(72) Inventor: CHEN, Taixian, Shenzhen, Guangdong 518129 (CN); XIA, Quanfei, Shenzhen, Guangdong 518129 (CN); ZHOU, Junlin, Shenzhen, Guangdong 518129 (CN); ZHAO, Fugao, Shenzhen, Guangdong 518129 (CN)
(74) Representative: Thun, Clemens
(86) International application number: PCT/CN2020/092664
(87) International publication number: WO 2021/027360

(56) References cited:
- CN-A- 109 546 429
- CN-A- 110 571 606
- CN-U- 207 265 339
- CN-U- 207 442 098
- CN-U- 207 504 271
- CN-U- 207 691 122
- US-B1- 6 540 564
- US-B2- 8 187 037
- US-B2- 10 326 246

## Description

### TECHNICAL FIELD

This application relates to the field of filtering technologies, and in particular, to a filter connection apparatus and a filtering method.

### BACKGROUND

With rapid development of power electronics technologies, in particular, the power electronics technologies are developing toward a high frequency, a high speed, and high sensitivity, a power electronics device has higher power, higher sensitivity, and a high capability of receiving a weak signal. An electromagnetic compatibility problem of the power electronics device increasingly becomes a core difficult problem and a research focus of the power electronics technologies. Due to the electromagnetic compatibility problem, a product may deteriorate in performance, or may even be damaged and cannot work.

Currently, a conventional solution to the electromagnetic compatibility problem is to add a filter, a magnetic ring, or a filtering assembly. The field of electric vehicles that is popular in recent years is used as an example. To resolve an electromagnetic compatibility problem of a device such as an on-board charger (On Board Charger, OBC) and a motor control unit (Motor Control Unit, MCU) of an electric vehicle, the filtering assembly usually needs to be additionally added to a main board of the OBC or the MCU.

For example, the filtering assembly usually includes one filter and two connectors. The two connectors are responsible for an input and an output of a signal. One connector is responsible for a connection between the filter and the main board of the OBC or the MCU, and the other connector is responsible for a connection between the filter and an external cable. The filter is responsible for signal filtering processing, so that the entire filtering assembly has a signal filtering capability.

On the main board of the OBC or the MCU, space needs to be respectively reserved for the two connectors and the one filter of the filtering assembly. Consequently, relatively large space needs to be reserved for the filtering assembly. This is not conducive to miniaturization of the vehicle-mounted OBC or the MCU.

Further, US 10 326 246 B2 refers to an electrical connector with filtering function including a high-speed interface, a filter module and a hood. The high-speed interface includes an insulating body and connecting terminals; the filter module is installed at a rear end of a circular crosssection of the insulating body; the filter module includes a lid with output terminals and grounding terminals and a horizontally configured PCB; and the grounding terminals include a first connecting end electrically connected to the PCB and a second connecting end integrally connected to the first connecting end and attached onto the external surface of the lid. The hood covers the lid and has a screw hole corresponding to the second connecting end for a locking screw being screwed in, and press tightly at the second connecting end to achieve the grounding and shielding of the PCB by the grounding terminal and the electrical connection of the locking screw to the hood.

Further, CN 109 546 429 A refers to a filter connector, which comprises a connector component and a tail cover sealing component. The connector component includes a shell, a contact component and a filter component. The shell is provided with an installation chamber penetrating the shell, and a ringshaped flange is arranged in the middle. The tail cover sealing component is installed on the flange. The contact component is installed in the installation chamber by plastic packaging. The filter component includes jacks, a printed circuit board, filters, and pins installed on the contact component. The filters are installed on the flange on the tail cover sealing component side, and partially extend out of the tail cover sealing component. The filters are electrically connected with the printed circuitboard. The jacks and part of the pins are welded to the printed circuit board.

### SUMMARY

This application provides a filter connection apparatus and a filtering method. In the present invention, a miniaturized filter board is used, and the filter board is integrated with a connector connected to an external signal, to greatly reduce occupied space, and facilitate miniaturization of a vehicle-mounted OBC or the MCU. In addition, the filter connection apparatus and the method in the present invention may also be applied to a power supply or another case in which there is an electromagnetic compatibility problem. This problem is solved by the subject matter of the independent claim. Further implementation forms are provided in the dependent claims.

According to a first aspect, at least one embodiment of this application provides a filter connection apparatus. The filter connection apparatus includes a first connector, a first filter board, and a second connector.

The first connector is connected to the second connector, the first connector has a cable connection interface and a first connection terminal electrically connected to the first filter board, the second connector has a main board connection terminal and a second connection terminal electrically connected to the first filter board, and the first filter board is configured to filter a signal transmitted between the first connector and the second connector.

In this embodiment of this application, the first connector is connected to the second connector, a cavity is formed between the first connector and the second connector, the first filter board is located inside the cavity, the first connector and the second connector are respectively connected to a cable and a main board of a device, and the first filter board performs filtering. The first connector, the first filter board, and the second connector form an integral structure, and a filter board that occupies very small space is selected, so that small space is occupied. Therefore, the filter connection apparatus occupies small space.

Optionally, the cavity is formed between the first connector and the second connector, and the first filter board is located inside the cavity.

In this implementation, the filter board is located inside the cavity formed between the first connector and the second connector, and does not occupy external space. Therefore, the filter connection apparatus occupies small space.

The first filter board has a plurality of filter circuits, and each of the plurality of filter circuits is configured to filter one signal.

In this implementation, a conventional manner in which the plurality of signals are processed in a unified manner is not used, and instead, the plurality of filter circuits are designed on the filter board, to respectively process a plurality of received signals, signals so that signal filtering is performed in a more targeted manner and has a better effect.

Optionally, the filter circuit is configured to: filter a signal input by the first connector, and filter a signal input by the second connector.

In this implementation, the filter circuit can filter the signal input by the first connector into the filter board, or can filter the signal input by the second connector into the filter board, to implement a bidirectional filtering function of the filter connection apparatus.

Optionally, the first filter board is at least one layer of printed circuit board, and each of the at least one layer of printed circuit board is provided with some of the plurality of filter circuits.

In this implementation, the first filter board is implemented by using the at least one layer of printed circuit board. When the first filter board is implemented by using a double-layer or multi-layer printed circuit board, the plurality of filter circuits may be disposed at layers, so that dimensions of the entire filter board can be reduced, to better meet a requirement for a miniaturization design.

In the apparatus of the invention, each filter circuit includes at least one filtering component; and
the plurality of filter circuits include at least one type of filter circuit, two filter circuits of different types include at least some different filtering components, and different types of filter circuits are configured to filter different types of signals.

In this implementation, there may be one or more types of filter circuits, and different types of filter circuits may be configured to process different types of signals, so that the filter board can meet a signal filtering processing requirement.

In the apparatus according to the invention, the filtering component includes at least one of the following: a common mode choke, a ferrite bead, and a capacitor, each type of filtering component included in the filter circuit includes one or more filtering components, and a connection manner of the filtering component in the filter circuit includes at least one of a series connection and a parallel connection.

In this implementation, the filter circuit is made of components such as the ferrite bead, the common mode choke, and the capacitor. In other words, in this application, the filter board performs filtering by using a power electronics technology instead of an electromagnetic technology. The dimensions of the filter board used for filtering by using the power electronics technology are far smaller than those of a filter used for filtering by using the electromagnetic technology, so that the miniaturization design can be implemented. In addition, each type of filtering component includes one or more filtering components, and the series connection and the parallel connection may be selected as the connection manner, so that a circuit design can be made based on a signal requirement, and the signal filtering processing requirement can be met.

Optionally, the filter connection apparatus further includes at least one second filter board, any of the at least one second filter board has same mounting dimensions as the first filter board, and a filtering component in a filter circuit on any of the at least one second filter board board has a specification different from a filtering component in at least one of the filter circuits on the first filter board.

In this implementation, the filter connection apparatus may be configured with a plurality of filter boards, the plurality of filter boards have same mounting dimensions, and components used in circuits have different specifications. In this case, the filter board may be replaced, to process signals of different magnitudes in a targeted manner. In addition, during replacement of the filter board, because a structure and dimensions of the filter board are not changed, a structure of the first connector and a structure of the second connector do not need to be changed, and replacement is more convenient.

Optionally, the first filter board has a plurality of pairs of jacks, the plurality of pairs of jacks are respectively connected to the plurality of filter circuits, and one filter circuit is connected between each of the plurality of pairs of jacks; and
each pair of jacks includes one first jack and one second jack, the second connector is electrically connected to the first jack on a side of the first filter board, and the first connector is electrically connected to the second jack on the other side of the first filter board.

In this implementation, the jacks are provided on the filter board to connect the first connector and the second connector, so that the first connector and the second connector are connected to the filter circuit. In this case, not only a connection, assembly, and disassembly are facilitated, but also a cable-free design of the filter connection apparatus can be implemented. There is no need to reserve arrangement space for a cable, to facilitate the miniaturization design.

Optionally, the second connector includes an adapter and a mounting cover; and
the mounting cover is connected to the first connector, an end of the adapter is used as the second connection terminal and is electrically connected to the first filter board, and the other end of the adapter protrudes from the mounting cover and is used as the main board connection terminal.

In this implementation, the second connector of the filter connection apparatus includes two parts. The two parts are used to not only facilitate assembly and disassembly, but also ensure an electrical connection to the filter board and the main board.

Optionally, the adapter includes a plurality of L-shaped pins arranged in parallel at spacings and an insulation material block, two ends of the L-shaped pin are respectively the second connection terminal and the main board connection terminal, and all the plurality of L-shaped pins pass through the insulation material block.

In this implementation, the filter connection apparatus can be directly plug-connected to the main board of the device by using the L-shaped pin, to facilitate mounting. In addition, the filter connection apparatus can be disposed on the main board of the device in parallel to a cable incoming direction by using the L-shaped pin, and small space is required in a direction perpendicular to the main board, so that a structure design around the main board can be more compact.

Optionally, the second connection terminal is plug-connected to the first jack, and a plurality of first jacks are in a one-to-one correspondence with the plurality of L-shaped pins.

In this implementation, the second connector is plug-connected to the first jack by using the L-shaped pin, so that not only assembly and disassembly can be facilitated, but also different signals can be transmitted by using different L-shaped pins in the second connector, to avoid mutual interference.

Alternatively, the mounting cover is a shielding can.

In this implementation, the shielding can is designed, to reduce interference of the main board to the filter circuit board, and ensure a filtering effect. In addition, interference of the filter circuit board to the main board can also be reduced.

Optionally, the first connector includes a housing and a pin located inside the housing, two ends of the housing respectively have a cable inlet and a connection portion connected to the second connector, an end of the pin is located inside the cable inlet, so that the pin and the cable inlet form the cable connection interface, and the other end of the pin protrudes from the connection portion to form the first connection terminal.

In this implementation, the housing whose two ends respectively have the cable inlet and the connection portion is used to implement a connection to the cable and the second connector, an end of the pin inside the housing is located inside the cable inlet, so that the pin and the cable inlet form the cable connection interface, and the other end of the pin protrudes from the connection portion to form the first connection terminal, to ensure that the first connector can be electrically connected to the cable and the filter board.

Optionally, the first connection terminal is plug-connected to the second jack, and a plurality of second jacks are in a one-to-one correspondence with to the plurality of pins.

In this implementation, the first connector is plug-connected to the second jack by using the pin, so that not only assembly and disassembly can be facilitated, but also different signals can be transmitted by using different pins in the first connector, to avoid mutual interference.

Optionally, the housing further includes a sealing plate located between the cable inlet and the connection end, and the pin passes through the sealing plate.

In this implementation, the sealing plate is disposed in the first connector, to seal an end connected to the cable, to avoid a case in which external moisture enters the cavity through the cable inlet, affecting stability of the filter connection apparatus.

Optionally, the first connector is detachably connected to the second connector.

In this implementation, the first connector is detachably connected to the second connector, to implement a detachable connection of the entire filter connection apparatus, and facilitate component replacement.

Optionally, the first connector and the second connector are connected by using a fastener, and the fastener connecting the first connector and the second connector passes through the first filter board.

In this implementation, the first connector and the second connector are connected by using the fastener, to implement the detachable connection. In addition, the fastener passes through the first filter board, to ensure stability of the filter board.

For example, the fastener may be a bolt, and the first filter board is provided with a through hole through which the bolt passes.

According to a second aspect, at least one embodiment of this application provides a filtering method, the filtering method is performed by the filter connection apparatus according to any implementation of the first aspect, and the filtering method includes:
obtaining a plurality of to-be-filtered signals;
filtering the plurality of signals by using the filter connection apparatus; and
outputting the plurality of filtered signals.

In this embodiment of this application, a conventional manner in which the plurality of signals are processed in a unified manner is not used, and instead, the plurality of filter circuits are designed on the filter board, to respectively process a plurality of received signals, signals so that signal filtering is performed in a more targeted manner and has a better effect.

### BRIEF DESCRIPTION OF DRAWINGS

FIG. 1 is a schematic structural diagram of a filter connection apparatus according to an embodiment of this application;
FIG. 2 is a schematic exploded view of the filter connection apparatus shown in FIG. 1;
FIG. 3 is a schematic structural diagram of a first connector in FIG. 1;
FIG. 4 is a view of the filter connection apparatus in FIG. 1 in another direction;
FIG. 5 to FIG. 8 are schematic structural diagrams of a double-layer printed circuit board according to an embodiment of this application;
FIG. 9 is a circuit diagram of a first filter circuit according to an embodiment of this application;
FIG. 10 is a circuit diagram of a second filter circuit according to an embodiment of this application;
FIG. 11 is a circuit diagram of a third filter circuit according to an embodiment of this application; and
FIG. 12 is a flowchart of a filtering method according to an embodiment of this application.

### DESCRIPTION OF EMBODIMENTS

To make objectives, technical solutions, and advantages of this application clearer, the following further describes implementations of this application in detail with reference to accompanying drawings.

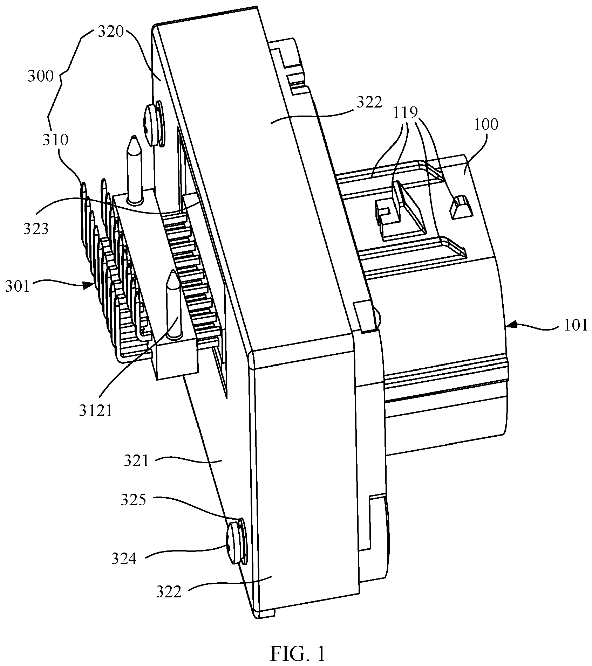

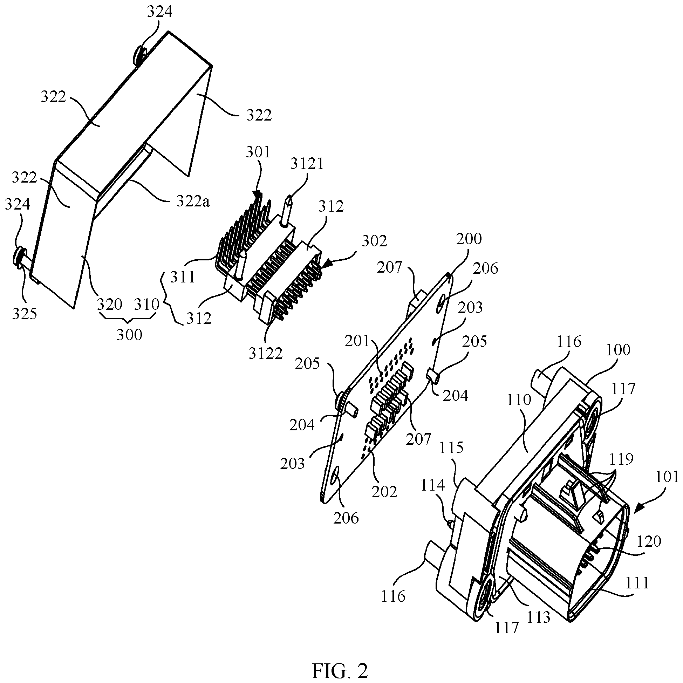

FIG. 1 is a schematic structural diagram of a filter connection apparatus according to an embodiment of this application. FIG. 2 is a schematic exploded view of the filter connection apparatus shown in FIG. 1. Refer to FIG. 1 and FIG. 2. The filter connection apparatus includes a first connector 100, a first filter board 200, and a second connector 300. The first connector 100 is connected to the second connector 300.

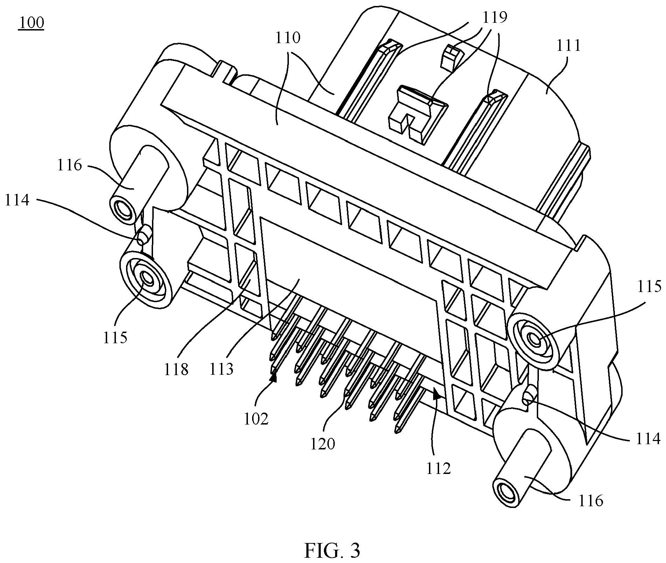

FIG. 3 is a schematic structural diagram of a first connector 100 in FIG. 1. Refer to FIG. 2 and FIG. 3. The first connector 100 has a cable connection interface 101 and a first connection terminal 102 that are disposed opposite to each other, the cable connection interface 101 of the first connector 100 is configured to be electrically connected to a cable, and the first connection terminal 102 of the first connector 100 is electrically connected to the first filter board 200.

Refer to FIG. 1 and FIG. 2 again. The second connector 300 has a main board connection terminal 301 and a second connection terminal 302 that are disposed opposite to each other, the second connection terminal 302 of the second connector 300 is electrically connected to the first filter board 200, and the main board connection terminal 301 of the second connector 300 is configured to be electrically connected to a main board of a device.

The first filter board 200 is configured to filter a signal transmitted between the first connector 100 and the second connector 300.

In this embodiment of this application, the first connector 100 is connected to the second connector 200, a cavity is formed between the first connector 100 and the second connector 300, the first filter board 200 is located inside the cavity, the first connector 100 and the second connector 300 are respectively connected to the cable and the main board of the device, and the first filter board 200 performs filtering. The first connector 100, the first filter board 200, and the second connector 300 form an integral structure, and a filter board that occupies very small space is selected, so that small space is occupied. Therefore, the filter connection apparatus occupies small space.

For example, the device may be an electric vehicle, and the main board may be a main board of an OBC of the electric vehicle, or a main board of an MCU. Correspondingly, the cable is a cable that is used to charge the OBC, or a cable that is used to supply power to the MCU or that is used to transmit a signal. For the main board of the OBC of the electric vehicle or the main board of the MCU, space is limited. The filter connection apparatus provided in this application occupies small space, and therefore, can meet a filtering requirement in this scenario. Certainly, the electric vehicle and the corresponding main board and cable types are only examples, and the filter connection apparatus provided in this application is also applicable to a signal filtering operation for another device.

In this embodiment of this application, the cavity (not shown in the figure) is formed between the first connector 100 and the second connector 300, and the first filter board 200 is located inside the cavity. Because the filter board is located inside the cavity formed between the first connector and the second connector, and does not occupy external space, the filter connection apparatus occupies small space.

As shown in FIG. 1 and FIG. 2, in an implementation of this application, the second connector 300 may include an adapter 310 and a mounting cover 320.

The mounting cover 320 is connected to the first connector 100, the cavity is formed between the mounting cover 320 and the first connector 100, an end of the adapter 310 is used as the second connection terminal 302 and is electrically connected to the first filter board 200, and the other end of the adapter 310 protrudes from the mounting cover 320 and is used as the main board connection terminal 301.

In this implementation, the second connector 300 of the filter connection apparatus includes two parts: the adapter 310 and the mounting cover 320. The two parts are used to not only facilitate assembly and disassembly, but also ensure an electrical connection to the first filter board 200 and the main board.

In an implementation of this application, the mounting cover 320 has a box structure. As shown in FIG. 1 and FIG. 2, the mounting cover 320 includes a rectangular bottom panel 321 and three side panels 322, the three side panels surround three sides of the rectangular bottom panel 321 and are arranged perpendicular to the rectangular bottom panel 321. As shown in FIG. 2, the fourth side of the rectangular bottom panel 321 is provided with a narrow side panel 322a perpendicular to the rectangular bottom panel 321, and a width of the narrow side panel 322a in a direction perpendicular to the rectangular bottom panel 321 is smaller than those of the other three side panels 322, to facilitate assembly of the mounting cover 320 and the first connector 100. The first connector 100 may be placed in the box structure from a side of the narrow side panel 322a, to complete assembly.

In another possible implementation, there may be more or fewer side panels 322. This is not limited in this application.

As shown in FIG. 1, the rectangular bottom panel 321 of the mounting cover 320 is provided with a through hole 323, so that the end that is of the adapter 310 and that is used as the main board connection terminal 301 passes through the through hole 323. For example, the through hole 323 may be rectangular.

A structure of the mounting cover in FIG. 1 and FIG. 2 is only an example. In another embodiment, the mounting cover 320 may alternatively be implemented in another shape.

Optionally, the mounting cover 320 may be a shielding can.

In this implementation, the shielding can is designed, to reduce interference of the main board to a filter circuit board, and ensure a filtering effect. In addition, interference of the filter circuit board to the main board can also be reduced.

For example, the mounting cover 320 is a metal mounting cover, so that the foregoing shielding effect can be achieved.

Refer to FIG. 2. The adapter 310 may include a plurality of L-shaped pins 311 arranged in parallel at spacings and an insulation material block 312, two ends of the L-shaped pin 311 are respectively the second connection terminal 302 and the main board connection terminal 301, and all the plurality of L-shaped pins 311 are fastened and positioned by passing through the insulation material block 312.

In this implementation, the filter connection apparatus can be directly inserted into the main board of the device by using the L-shaped pin 311, to facilitate mounting. In addition, the filter connection apparatus can be disposed on the main board of the device in parallel to a cable incoming direction by using the L-shaped pin 311, and small space is required in a direction perpendicular to the main board, so that a structure design around the main board can be more compact.

As shown in FIG. 2, the plurality of L-shaped pins 311 may be disposed in two rows, to reduce space occupied by the L-shaped pins 311, and facilitate miniaturization of the filter connection apparatus. In another possible implementation, the plurality of L-shaped pins 311 may alternatively be disposed in more or fewer rows, for example, one row or three rows.

As shown in FIG. 2, the plurality of L-shaped pins 311 may be fastened by using two insulation material blocks 312 arranged at spacings, so that the plurality of L-shaped pins 311 are more stable. In another possible implementation, more or fewer insulation material blocks 312, for example, one insulation material block 312 or three insulation material blocks, may be arranged.

For example, one insulation material block 312 is provided with two positioning posts 3121, and extension directions of the two positioning posts 3121 are parallel to an extension direction of the end that is of the L-shaped pin 311 and that is used as the main board connection terminal 301.

The positioning post 3121 is assembled with a positioning hole on the main board of the device, to facilitate positioning, and facilitate a connection between the second connector 300 and the main board. The insulation material block 312 provided with the positioning post 3121 is located outside the through hole 323 of the rectangular bottom panel 321, to ensure a connection to the main board.

As shown in FIG. 2, the other insulation material block 312 is provided with two positioning pins 3122, and extension directions of the two positioning pins 3122 are parallel to an extension direction of the end that is of the L-shaped pin 311 and that is used as the second connection terminal 302.

Herein, dimensions of the positioning pins 3122 are similar to dimensions of an end of the L-shaped pin 311.

As shown in FIG. 2, there is a first jack 201 on the first filter board 200, and the L-shaped pin 311 may be plug-connected to the first jack 201. As shown in FIG. 2, there are a plurality of first jacks 201 into which L-shaped pins 311 are inserted, the second connection terminal 302 is plug-connected to the first jack 201, and the plurality of first jacks 201 are in a one-to-one correspondence with the plurality of L-shaped pins 311. In other words, each first jack 201 is plug-connected to one second connection terminal 302. A quantity of first jacks 201 into which L-shaped pins 311 are inserted may be set based on an actual requirement. For example, the first jacks 201 into which the L-shaped pins 311 are inserted may be arranged in two rows. In addition, two first jacks 201 into which the positioning pins 3122 are inserted may be further disposed. The two first jacks 201 are disposed outside the two rows, to facilitate distinguishing.

The positioning pin 3122 cooperates with the first jack 201 on the filter board of the device, to help positioning and assembly of the adapter 310 and the first filter board 200. The insulation material block 312 provided with the positioning pin 3122 is located in the through hole 323 of the rectangular bottom panel 321, and the positioning pin 3122 protrudes toward the filter board from the through hole 323, to be plug-connected to the first jack 201 on the filter board. The insulation material block 312 is disposed in the through hole 323, to ensure that the L-shaped pin 311 is insulated from the shielding can, and avoid a short circuit between a plurality of lines.

In this embodiment of this application, the positioning post 3121 and the positioning pin 3122 may be made of a same material as the insulation material block 312, and are designed by using an integrated molding process.

For example, the adapter 310 may be formed through injection molding. To be specific, the plurality of L-shaped pins 311 are placed in an injection mold, and the insulation material block 312 wrapping the plurality of L-shaped pins 311 and the positioning post 3121 are formed through injection molding.

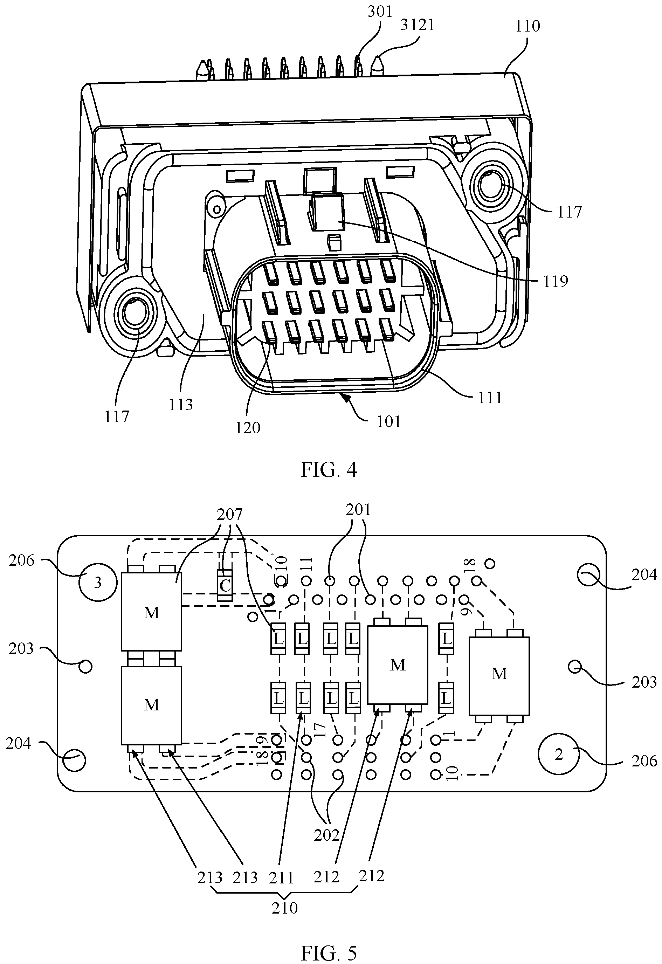

FIG. 4 is a view of the filter connection apparatus in FIG. 1 in another direction. As shown in FIG. 2 to FIG. 4, in an implementation of this application, the first connector 100 includes a housing 110 and a pin 120 located inside the housing 110, two ends of the housing 110 respectively have a cable inlet 111 and a connection portion 112 connected to the second connector 300, an end of the pin 120 is located inside the cable inlet 111, so that the pin 120 and the cable inlet 111 form the cable connection interface 101, and the other end of the pin 120 protrudes from the connection portion 112 to form the first connection terminal 102.

In this implementation, the housing 110 whose two ends respectively have the cable inlet 111 and the connection portion 112 is used to implement a connection to the cable and the second connector 300, an end of the pin 120 inside the housing 110 is located inside the cable inlet 111, so that the pin 120 and the cable inlet 111 form the cable connection interface 101, and the other end of the pin 120 protrudes from the connection portion 112 to form the first connection terminal 102, to ensure that the pin 120 can be electrically connected to the cable and the first filter board 200.

As shown in FIG. 2 and FIG. 3, pins 120 may be arranged in a plurality of rows, and the pin 120 may be bent inside the housing 110, so that a quantity of rows at the cable connection interface 101 is different from a quantity of rows at the first connection terminal 102.

For example, the first connector 100 includes 18 pins 120, the 18 pins 120 are disposed in three rows at the cable connection interface 101, and the 18 pins 120 are disposed in two rows at the first connection terminal 102. Herein, a quantity of pins 120 and a quantity of rows are merely examples. In another possible implementation, more or fewer pins 120 and more or fewer rows may be designed.

As shown in FIG. 2, there is a second jack 202 on the first filter board 200, and the pin 120 of the first connection terminal 102 may be plug-connected to the second jack 202. As shown in FIG. 2, there are a plurality of second jacks 202, the first connection terminal 102 is plug-connected to the second jack 202, and the plurality of second jacks 202 are in a one-to-one correspondence with the plurality of pins 120. In other words, one first connection terminal 102 is plug-connected to each second jack 202. A quantity of second jacks 202 may be set based on an actual requirement. For example, the second jack 202 may be disposed in three rows, so that three rows of pins 120 are inserted into the three rows.

As shown in FIG. 2 to FIG. 4, the housing 110 may further include a sealing plate 113 located between the cable inlet 111 and the connection portion 112, and the pin 120 passes through the sealing plate 113.

In this implementation, the sealing plate is disposed in the first connector, to seal an end connected to the cable, to avoid a case in which external moisture enters the cavity through the cable inlet, affecting stability of the filter connection apparatus.

As shown in FIG. 2 and FIG. 3, a side that is of the connection portion 112 of the housing 110 and that faces the second connector 300 is provided with a positioning post 114, and the first filter board 200 is provided with a positioning hole 203 corresponding to the positioning post 114.

In this implementation, the positioning post 114 and the positioning hole 203 are designed to position the first connector 100 and the first filter board 200, to facilitate mounting.

As shown in FIG. 2 and FIG. 3, the housing 110 is provided with a mounting screw hole 115. For example, as shown in FIG. 3, the housing 110 is provided with two diagonally arranged mounting screw holes 115.

Correspondingly, the first filter board 200 is provided with a first through hole 204, and the bolt 205 passes through the first through hole 204 and the mounting screw hole 105 in the housing 110, to position the first filter board 200 and the first connector 100.

As shown in FIG. 2 and FIG. 3, a side that is of the housing 110 and that faces the second connector 300 is provided with a stud 116. For example, as shown in FIG. 3, the housing 110 is provided with two diagonally arranged studs 116, and the two studs 116 and the foregoing two mounting screw holes 115 are arranged at four corners. As shown in FIG. 2 and FIG. 4, a side that is of the housing 110 and that is opposite to the second connector 300 is provided with a nut mounting hole 117 communicating with the stud 116.

Correspondingly, the first filter board 200 is provided with a second through hole 206, and the mounting cover 320 is provided with a through hole (not shown in the figure).

The stud 116 passes through the second through hole 206 and then is aligned with the through hole in the mounting cover 320, and the bolt 324 in the mounting cover 320 sequentially passes through the through hole in the mounting cover 320, the stud 116, and the nut mounting hole 117, and is threadedly connected to a nut (not shown in the figure) in the nut mounting hole 117.

In the foregoing implementation, the first connector 100, the first filter board 200, and the second connector 300 are assembled and fastened with good stability and are easily disassembled and assembled.

Optionally, a gasket 325 is disposed between the bolt 324 and the mounting cover 320 for cushioning.

As shown in FIG. 2 and FIG. 3, the connection portion 112 is of a cuboid structure, and a side that is of the connection portion 112 and that faces the second connector 300 is provided with the positioning post 114, the mounting screw hole 115, the stud 116, and the like.

For example, a side that is of the connection portion 112 and that faces the second connector 300 is further provided with a plurality of grooves 118, the grooves 118 do not pass through the sealing plate 113, and the grooves 118 may be used to reduce an overall weight of the housing 100, to implement a lightweight design of the filter connection apparatus.

As shown in FIG. 2 and FIG. 3, the cable inlet 111 is a cylindrical structure, an outer surface of the cylindrical structure is provided with a snap-on structure 119, and the snap-on structure 119 is configured to be snapped with a connection of the cable when the connection of the cable is inserted into the cable inlet 111.

A structure of the housing 110 in FIG. 2 and FIG. 3 is only an example. In another embodiment, the housing 110 may alternatively be implemented in another shape.

Refer to FIG. 2 again. A filtering component 207 is arranged on the first filter board 200, and the filtering component 207 is configured to form a filter circuit.

According to the invention, the first filter board 200 has a plurality of filter circuits, and each of the plurality of filter circuits is configured to filter one signal.

In this implementation, a conventional manner in which the plurality of signals are processed in a unified manner is not used, and instead, the plurality of filter circuits are designed on the first filter board 200, to respectively process a plurality of received signals,signals so that signal filtering is performed in a more targeted manner and has a better effect.

Optionally, the filter circuit is configured to: filter a signal input by the first connector 100, and filter a signal input by the second connector 300.

In this implementation, the filter circuit can filter the signal input by the first connector into the filter board, or can filter the signal input by the second connector into the filter board, to implement a bidirectional filtering function of the filter connection apparatus.

In a possible implementation, each of the plurality of filter circuits may filter the signal input by the first connector 100 and the signal input by the second connector 300.

In another possible implementation, only some of the plurality of filter circuits can filter the signal input by the first connector 100 and filter the signal input by the second connector 300. The remaining filter circuits in the plurality of filter circuit can only filter the signal input by the first connector 100 or filter the signal input by the second connector 300.

Each filter circuit includes at least one filtering component 207, the plurality of filter circuits may include at least one type of filter circuit, two filter circuits of different types include at least some different filtering components 207, and different types of filter circuits are configured to filter different types of signals.

In this implementation, there may be one or more types of filter circuits, and different types of filter circuits may be configured to process different types of signals, so that the filter board can meet a signal filtering processing requirement.

The filtering component 207 includes at least one of the following: a common mode choke, a ferrite bead, and a capacitor, each type of filtering component 207 included in the filter circuit includes one or more filtering components 207, and a connection manner of the filtering component 207 in the filter circuit includes at least one of a series connection and a parallel connection.

In this implementation, the filter circuit is made of components such as the ferrite bead, the common mode choke, and the capacitor. In other words, in this application, the filter board performs filtering by using a power electronics technology instead of an electromagnetic technology. The filter board used for filtering by using the power electronics technology is far smaller than a filter used for filtering by using the electromagnetic technology, so that the miniaturization design can be implemented. In addition, each type of filtering component includes one or more filtering components, and the series connection and the parallel connection may be selected as the connection manner, so that a circuit design can be made based on a signal requirement, and the signal filtering processing requirement can be met.

Optionally, the first filter board 200 has a plurality of pairs of jacks, the plurality of pairs of jacks are respectively connected to the plurality of filter circuits, and one filter circuit is connected between each pair of jacks; and each pair of jacks includes one first jack 201 and one second jack 202, the second connector 300 is electrically connected to the first jack 201 on a side of the first filter board 200, and the first connector 100 is electrically connected to the second jack 202 on the other side of the first filter board 200. In other words, the first connector 100 and the second connector 300 are connected to the first filter board 200 on opposite sides of the first filter board 200.

In this implementation, the jacks are provided on the first filter board 200 to connect the first connector 100 and the second connector 300. In this case, not only a connection and disassembly are facilitated, but also a cable-free design of the filter connection apparatus can be implemented. There is no need to reserve arrangement space for the cable, to facilitate the miniaturization design.

In an implementation of this embodiment of this application, the first filter board 200 may be at least one layer of printed circuit board, and each of the at least one layer of printed circuit board is provided with some of the plurality of filter circuits. The at least one layer of printed circuit board is a single-layer printed circuit board or a combination of two or more layers of printed circuit boards, and the filtering component 207 is disposed on each layer of printed circuit board. For example, in a double-layer printed circuit board, the filtering component 207 is disposed on both sides of the double-layer printed circuit board.

In this implementation, the first filter board is implemented by using the at least one layer of printed circuit board. When the first filter board is implemented by using a double-layer or multi-layer printed circuit board, the plurality of filter circuits may be disposed at layers, so that dimensions of the entire first filter board 200 can be reduced, to better meet a requirement for the miniaturization design.

In another implementation, the first filter board 200 may alternatively be a single-layer printed circuit board.

A structure of the filter board in this application is described below by using the double-layer printed circuit board as an example. Each layer of printed circuit board in the double-layer printed circuit board includes a front side and a back side, wiring is performed on a side that is of each layer of printed circuit board and that faces the other layer of printed circuit board, and the filtering component 207 is arranged on a side (namely, a side that faces the outside) that is of each layer of printed circuit board and that is opposite to the other layer of printed circuit board.

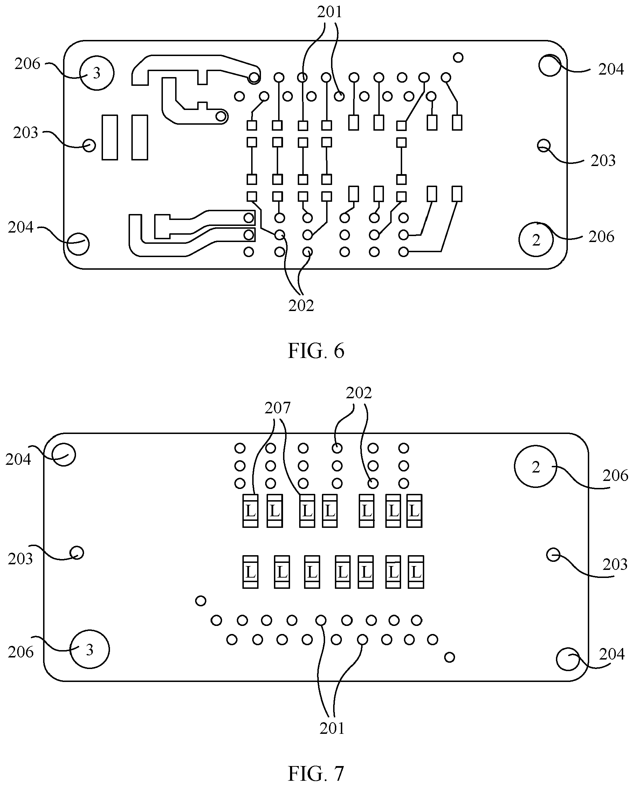

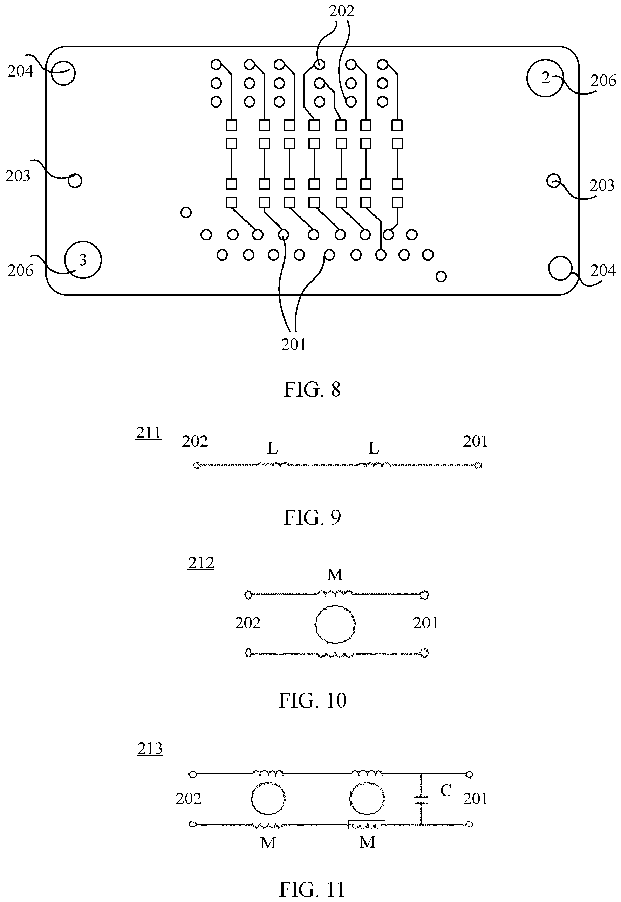

FIG. 5 to FIG. 8 are schematic structural diagrams of a double-layer printed circuit board according to an embodiment of this application. FIG. 5 is a circuit diagram of a top side of a first layer of printed circuit board. FIG. 6 is a circuit diagram of a bottom side (which faces a second layer of printed circuit board) of a first layer of printed circuit board. FIG. 7 is a circuit diagram of a bottom side of a second layer of printed circuit board. FIG. 8 is a circuit diagram of a top side (which faces a first layer of printed circuit board) of the second layer of printed circuit board.

As shown in FIG. 5 to FIG. 8, each layer of printed circuit board is provided with the first jack 201, the second jack 202, the positioning hole 203, the first through hole 205, and the second through hole 206.

Two second through holes 206 in the figure are respectively numbered "2" and "3". In the double-layer printed circuit board, second through holes 206 whose numbers are 2 are aligned, and second through holes 206 whose numbers are 3 are aligned.

Refer to FIG. 5. 18 first jacks 201 into which L-pins are inserted are designed on the first layer of printed circuit board, and 18 second jacks 202 are also designed. The 18 first jacks 201 and the 18 second jacks 202 are disposed in pairs. A first jack 201 and a second jack 202 in each pair are connected to a same filtering component, to form a filter circuit. Jacks in the filter circuit are two connection ends of the filter circuit. In another possible implementation, more or fewer first jacks 201 and more or fewer second jacks 202 may be designed based on a requirement.

For example, in FIG. 5, a first jack 201 whose number is 1 and a second jack 202 whose number is 9 are a pair, a first jack 201 whose number is 10 and a second jack 202 whose number is 18 are a pair, a first jack 201 whose number is 9 and a second jack 202 whose number is 1 are a pair, and a first jack 201 whose number is 18 and a second jack 202 whose number is 10 are a pair. The numbers herein are only examples, and may be actually set based on a requirement.

In these jacks disposed in pairs, a circuit connected to some pairs of jacks is located on the first layer of printed circuit board, and a circuit connected to the other pairs of jacks is located on the second layer of printed circuit board.

As shown in FIG. 5, a filtering component is disposed on the top side of the first layer of printed circuit board, and filtering components located on the top side of the first layer of printed circuit board include a common mode choke M, a capacitor C, and a ferrite bead L. Pins of these filtering components pass through the printed circuit board in a direction perpendicular to the top side, are disposed on the bottom side of the first layer of printed circuit board, and are connected through a line on the bottom side, to be specific, a dotted line in FIG. 5.

For example, the first filter board 200 has a plurality of filter circuits 210, for example, a first filter circuit 211, a second filter circuit 212, and a third filter circuit 213. Each of the plurality of filter circuits 210 has two connection ends, and the two connection ends of the filter circuit in this application are a pair of jacks (one first jack 201 and one second jack 202) on the filter board.

The first filter circuit 211 has two ferrite beads L that are connected in series, and two ends of the two ferrite beads L that are connected in series are respectively connected to two connection ends of the first filter circuit 211. FIG. 9 is a circuit diagram of a first filter circuit 211 according to an embodiment of this application. Refer to FIG. 5 and FIG. 9. Two ferrite beads L that are connected in series are connected between a first jack 201 whose number is 11 and a second jack 202 whose number is 17. Herein, a quantity of ferrite beads that are connected in series in the first filter circuit may be greater than 2.

Two second filter circuits 212 share one common mode choke M, two ends of a coil of the common mode choke M are connected to two connection ends of one second filter circuit 212, and two ends of the other coil of the common mode choke M are connected to two connection ends of the other second filter circuit 212. FIG. 10 is a circuit diagram of a second filter circuit 212 according to an embodiment of this application. Refer to FIG. 5 and FIG. 10. A first jack 201 whose number is 9, a second jack 202 whose number is 1, a first jack 202 whose number is 18, and a second jack 202 whose number is 10 are connected to a same common mode choke M. A second filter circuit is formed between the first jack 201 whose number is 9 and the second jack 202 whose number is 1, and another second filter circuit is formed between the first jack 201 whose number is 18 and the second jack 202 whose number is 10. The common mode choke M has two coils, and each coil is used for one filter circuit.

Two third filter circuits 213 share two common mode chokes M that are connected in series, two ends of a path of coils that are connected in series and that are of the two common mode chokes M are connected to two connection ends of one third filter circuit 213, two ends of the other path of coils that are connected in series and that are of two common mode chokes M are connected to two connection ends of the other third filter circuit 213, and two connection ends that are of the two third filter circuits 213 and that are connected to a same common mode choke M are respectively connected to two ends of the capacitor C. FIG. 11 is a circuit diagram of a third filter circuit 213 according to an embodiment of this application. Refer to FIG. 5 and FIG. 11. The first jack 201 whose number is 1, the second jack 202 whose number is 9, the first jack 202 whose number is 10, and the second jack 202 whose number is 18 are connected to two common mode chokes M that are connected in series. A capacitor C is connected between the first jack 201 whose number is 1 and the first jack 202 whose number is 10, a third filter circuit is formed between the first jack 201 whose number is 1 and the second jack 202 whose number is 9, and another third filter circuit is formed between the first jack 201 whose number is 10 and the second jack 202 whose number is 18. The two common mode chokes M that are connected in series form two paths of coils that are connected in series, and each path of coils that are connected in series is used for one filter circuit. Herein, a quantity of common mode chokes that are connected in series in the third filter circuit may be greater than 2.

In this implementation, the filter circuit is made of components such as the ferrite bead, the common mode choke, and the capacitor. In other words, in this application, the first filter board 200 performs filtering by using a power electronics technology instead of an electromagnetic technology. The first filter board 200 used for filtering by using the power electronics technology is far smaller than a filter used for filtering by using the electromagnetic technology, so that the miniaturization design can be implemented.

It should be noted that a plurality of circuits on the first filter board 200 may include only one or several types of filter circuits in the first filter circuit to the third filter circuit. There may be one or more types of filter circuits, and different types of filter circuits may be configured to process different types of signals, so that the filter board can meet a signal filtering processing requirement.

As shown in FIG. 6, the pins of the foregoing filtering component and a line connecting these pins are disposed on the bottom side of the first layer of printed circuit board. Details are not described herein.

A circuit distribution in FIG. 7 and FIG. 8 is similar to that in FIG. 5 and FIG. 6. A difference is that only the first filter circuit is disposed on the second layer of printed circuit board, and the second filter circuit and the third filter circuit are not disposed. Certainly, a circuit distribution on each layer of printed circuit board may be in another manner. This is not limited herein.

In an embodiment of the present disclosure, specifications of the filtering components on the first filter board 200 may be selected as follows:
a. The common mode choke M is a vehicle-mounted (power-type) electromagnetic interference (Electromagnetic Interference, EMI) common mode choke, and packaging dimensions are 9.2 mm x 7.2 mm x 4.5 mm.
b. For the capacitor C, a capacity is 4.7 uF±10%, a rated voltage is 35 V, and a manufacturer model is CGA4J1X7R1V475KT000N.
c. There two types of ferrite beads L: For a first type, a resistance value is 600 ohm, impedance is 600 ohm±30%, a frequency is 100 MHz, a type is a 0805 package patch, and a patch thickness ≤ 3 mm; for a second type, a resistance range is 2000-2250 ohm, impedance is 2000-2250 ohm±20%, a frequency is 100 MHz, a type is a 0805 package patch, and a patch thickness ≤ 3 mm. Herein, the two types of ferrite beads may be selected based on a signal corresponding to a filter circuit on the filter board. For example, the first type of ferrite bead may be selected for a first filter circuit that is configured to process a wakeup output signal (PSR_ out), and the second type of ferrite bead may be selected for a first filter circuit that is configured to process another signal.

In an embodiment of the present disclosure, the filter connection apparatus may further include at least one second filter board 400, any of the at least one second filter board 400 has same mounting dimensionss as the first filter board 200, and a filtering component in a filter circuit on any of the at least one second filter board 400 has a specification different from a filtering component in at least one of the filter circuits on the first filter board 200.

Herein, the mounting dimensions are positions, quantities, and dimensions of the first jack 201, the second jack 202, the positioning hole 203, the first through hole 205, and the second through hole 206 on the filter board. It needs to be ensured that the positions, the quantities, and the dimensions of these holes are the same. Even if dimensions of outer contours of mounting plates are different, the filter board can be replaced provided that the filter board can be accommodated in the cavity.

That the filtering component has a different specification may mean that the filtering component has any one or more different electrical parameters, for example, a resistance value, a frequency, a rated voltage, and a capacitance value.

In this implementation, the filter connection apparatus may be configured with a plurality of filter boards, the plurality of filter boards have same mounting dimensions, and components used in circuits have different specifications. In this case, the filter board may be replaced, to process signals of different types and signals with different specifications (magnitudes of the signals) in a targeted manner. In addition, during replacement of the filter board, because a structure and dimensions of the filter board are not changed, a structure of the first connector and a structure of the second connector do not need to be changed, and replacement is more convenient.

The filter connection apparatus provided in this embodiment of this application may be configured to perform signal filtering for devices in various fields, for example, a signal filtering operation for the main board of the OBC/MCU of the electric vehicle.

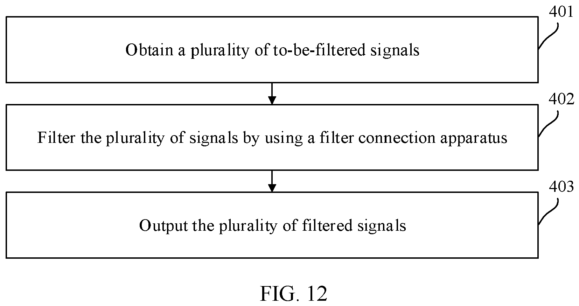

FIG. 12 is a flowchart of a filtering method according to an embodiment of this application. The filtering method is performed by the filter connection apparatus as shown in FIG. 1 to FIG. 11. The filtering method includes the following steps.

Step 401: Obtain a plurality of to-be-filtered signals.

Herein, the to-be-filtered signal may be a signal that is obtained by a first connector and that is transmitted through a cable, or may be a signal that is obtained by a second connector and that is output by a main board of a device.

Step 402: Filter the plurality of signals by using the filter connection apparatus.

For example, a conventional manner in which the plurality of signals are processed in a unified manner is not used, and instead, a first filter board 200 of the filter connection apparatus respectively process, by using a plurality of filter circuits designed on the first filter board 200, a plurality of received signals,signals so that signal filtering is performed in a more targeted manner and has a better effect.

Step 403: Output the plurality of filtered signals.

For example, a plurality of signals output by the filter board is sent to the main board of the device through the second connector, or a plurality of signals output by the filter board is sent to the cable through the first connector.

The foregoing descriptions are not intended to limit the protection scope of this application. Therefore, the protection scope of this application shall be subject to the protection scope of the claims.

## Claims

1. A filter connection apparatus, wherein the filter connection apparatus comprises a first connector (100), a first filter board (200), and a second connector (300); and
• the first connector (100) is connected to the second connector (300), the first connector (100) has a cable connection interface (101) and a first connection terminal (102) electrically connected to the first filter board (200),
• the second connector (300) has a main board connection terminal (301) and a second connection terminal (302) electrically connected to the first filter board (200),
• the first filter board (200) is configured to filter a signal transmitted between the first connector (100) and the second connector (300),
• wherein the first filter board (200) has a plurality of filter circuits (210), and each of the plurality of filter circuits (210) is configured to filter one signal, **characterized in that**
each filter circuit (210) comprises at least one filtering component (207), and the plurality of filter circuits (210) comprise at least one type of filter circuit (210), two filter circuits (210) of different types comprise at least some different filtering components (207), and different types of filter circuits (210) are configured to filter different types of signals, wherein the filtering component (207) comprises at least one of the following: a common mode choke, a ferrite bead, and a capacitor, each type of filtering component (207) comprised in the filter circuit (210) comprises one or more filtering components, and a connection manner of the filtering component (207) in the filter circuit (210) comprises at least one of a series connection and a parallel connection.

2. The filter connection apparatus according to claim 1, wherein a cavity is formed between the first connector (100) and the second connector (300), and the first filter board (200) is located inside the cavity.

3. The filter connection apparatus according to claim 1, wherein the filter circuit (210) is configured to: filter a signal input by the first connector (100), and filter a signal input by the second connector (300).

4. The filter connection apparatus according to claim 1, wherein the first filter board (200) is at least one layer of printed circuit board, and each of the at least one layer of printed circuit board is provided with some of the plurality of filter circuits (210).

5. The filter connection apparatus according to claim 1, wherein the filter connection apparatus further comprises at least one second filter board, any of the at least one second filter board has same mounting dimensions as the first filter board (200), and a filtering component in a filter circuit on any of the at least one second filter board has a specification different from a filtering component (207) in at least one of the filter circuits on the first filter board (200).

6. The filter connection apparatus according to any one of claims 1 to 5, wherein the first filter board (200) has a plurality of pairs of jacks, the plurality of pairs of jacks are respectively connected to the plurality of filter circuits (210), and one filter circuit (210) is connected between each of the plurality of pairs of jacks; and
each pair of jacks comprises one first jack (201) and one second jack (202), the second connector (300) is electrically connected to the first jack (201) on a side of the first filter board (200), and the first connector (100) is electrically connected to the second jack (202) on the other side of the first filter board (200).

7. The filter connection apparatus according to claim 6, wherein the second connector (300) comprises an adapter (310) and a mounting cover (320); and
the mounting cover (320) is connected to the first connector (100), an end of the adapter (310) is used as the second connection terminal (302) and is electrically connected to the first filter board (200), and the other end of the adapter (310) protrudes from the mounting cover (320) and is used as the main board connection terminal (301).

8. The filter connection apparatus according to claim 7, wherein the adapter (310) comprises a plurality of L-shaped pins (311) arranged in parallel at spacings and an insulation material block (312), two ends of the L-shaped pin (311) are respectively the second connection terminal (302) and the main board connection terminal (301), and all the plurality of L-shaped pins (311) pass through the insulation material block (312).

9. The filter connection apparatus according to claim 8, wherein the second connection terminal (302) is plug-connected to the first jack (201), and a plurality of first jacks (201) are in a one-to-one correspondence with the plurality of L-shaped pins (311).

10. The filter connection apparatus according to claim 7, wherein the mounting cover (320) is a shielding can.

11. The filter connection apparatus according to claim 6, wherein the first connector (100) comprises a housing (110) and a pin (120) located inside the housing (110), two ends of the housing (110) respectively have a cable inlet (111) and a connection portion (112) connected to the second connector (300), an end of the pin (120) is located inside the cable inlet (111), so that the pin (120) and the cable inlet (111) form the cable connection interface (101), and the other end of the pin (120) protrudes from the connection portion (112) to form the first connection terminal (102).

12. The filter connection apparatus according to any one of claims 1 to 5, wherein the first connector (100) and the second connector (300) are connected by using a fastener, and the fastener connecting the first connector (100) and the second connector (300) passes through the first filter board (200).

## Patentansprüche

1. Filterverbindungsvorrichtung, wobei die Filterverbindungsvorrichtung einen ersten Verbinder (100), eine erste Filterplatine (200) und einen zweiten Verbinder (300) umfasst; und
• der erste Verbinder (100) mit dem zweiten Verbinder (300) verbunden ist, wobei der erste Verbinder (100) eine Kabelverbindungsschnittstelle (101) und einen ersten Verbindungsanschluss (102), der mit der ersten Filterplatine (200) verbunden ist, aufweist,
• der zweite Verbinder (300) einen Hauptplatinen-Verbindungsanschluss (301) und einen zweiten Verbindungsanschluss (302), der mit der ersten Filterplatine (200) elektrisch verbunden ist, aufweist,
• die erste Filterplatine (200) zum Filtern eines zwischen dem ersten Verbinder (100) und dem zweiten Verbinder (300) übertragenen Signals konfiguriert ist,
• wobei die erste Filterplatine (200) mehrere Filterschaltungen (210) aufweist, wobei jede der mehreren Filterschaltungen (210) zum Filtern eines Signals konfiguriert ist, **dadurch gekennzeichnet, dass**
jede Filterschaltung (210) wenigstens eine Filterungskomponente (207) umfasst und die mehreren Filterschaltungen (210) wenigstens einen Typ einer Filterschaltung (210) umfassen, wobei zwei Filterschaltungen (210) unterschiedlicher Typen wenigstens einige verschiedene Filterungskomponenten (207) umfassen und wobei unterschiedliche Typen von Filterschaltungen (210) zum Filtern unterschiedlicher Typen von Signalen konfiguriert sind, wobei die Filterungskomponente (207) wenigstens eines der Folgenden umfasst: eine Gleichtaktdrosselspule, eine Ferritperle und einen Kondensator, wobei jeder Typ einer in der Filterschaltung (210) enthaltenen Filterungskomponente (207) eine oder mehrere Filterungskomponenten umfasst und wobei eine Verbindungsart der Filterungskomponente (207) in der Filterschaltung (210) eine Reihenschaltung und/oder eine Parallelschaltung umfasst.

2. Filterverbindungsvorrichtung nach Anspruch 1, wobei zwischen dem ersten Verbinder (100) und dem zweiten Verbinder (300) ein Hohlraum gebildet ist und wobei sich die erste Filterplatine (200) innerhalb des Hohlraums befindet.

3. Filterverbindungsvorrichtung nach Anspruch 1, wobei die Filterschaltung (210) konfiguriert ist zum: Filtern eines durch den ersten Verbinder (100) eingegebenen Signals und Filtern eines durch den zweiten Verbinder (300) eingegebenen Signals.

4. Filterverbindungsvorrichtung nach Anspruch 1, wobei die erste Filterplatine (200) wenigstens eine Schicht einer Leiterplatte ist und jede der wenigstens einen Schicht der Leiterplatte mit einigen der mehreren Filterschaltungen (210) versehen ist.

5. Filterverbindungsvorrichtung nach Anspruch 1, wobei die Filterverbindungsvorrichtung ferner wenigstens eine zweite Filterplatine umfasst, wobei irgendeine der wenigstens einen zweiten Filterplatine dieselben Einbauabmessungen wie die erste Filterplatine (200) aufweist und wobei eine Filterungskomponente in einer Filterschaltung auf irgendeiner der wenigstens einen zweiten Filterplatine eine Spezifikation aufweist, die von einer Filterungskomponente (207) in wenigstens einer der Filterschaltungen auf der ersten Filterplatine (200) verschieden ist.

6. Filterverbindungsvorrichtung nach einem der Ansprüche 1 bis 5, wobei die erste Filterplatine (200) mehrere Paare von Buchsen aufweist, wobei die mehreren Paare von Buchsen jeweils mit den mehreren Filterschaltungen (210) verbunden sind und wobei zwischen jedem der mehreren Paare von Buchsen eine Filterschaltung (210) verbunden ist; und
jedes Paar von Buchsen eine erste Buchse (201) und eine zweite Buchse (202) umfasst, wobei der zweite Verbinder (300) auf einer Seite der ersten Filterplatine (200) mit der ersten Buchse (201) elektrisch verbunden ist und wobei der erste Verbinder (100) auf der anderen Seite der ersten Filterplatine (200) mit der zweiten Buchse (202) elektrisch verbunden ist.

7. Filterverbindungsvorrichtung nach Anspruch 6, wobei der zweite Verbinder (300) einen Adapter (310) und eine Einbauabdeckung (320) umfasst; und
die Einbauabdeckung (320) mit dem ersten Verbinder (100) verbunden ist, wobei ein Ende des Adapters (310) als der zweite Verbindungsanschluss (302) verwendet ist und mit der ersten Filterplatine (200) elektrisch verbunden ist und das andere Ende des Adapters (310) von der Einbauabdeckung (320) vorsteht und als der Hauptplatinen-Verbindungsanschluss (301) verwendet ist.

8. Filterverbindungsvorrichtung nach Anspruch 7, wobei der Adapter (310) mehrere L-förmige Anschlussstifte (311), die in Abständen parallel angeordnet sind, und einen Isoliermaterialblock (312) umfasst, wobei zwei Enden des L-förmigen Anschlussstifts (311) der zweite Verbindungsanschluss (302) bzw. der Hauptplatinen-Verbindungsanschluss (301) sind und wobei alle der mehreren L-förmigen Anschlussstifte (311) durch den Isoliermaterialblock (312) gehen.

9. Filterverbindungsvorrichtung nach Anspruch 8, wobei der zweite Verbindungsanschluss (302) in die erste Buchse (201) eingesteckt ist und wobei mehrere erste Buchsen (201) mit den mehreren L-förmigen Anschlussstiften (311) in einer eineindeutigen Entsprechung stehen.

10. Filterverbindungsvorrichtung nach Anspruch 7, wobei die Einbauabdeckung (320) eine Abschirmkappe ist.

11. Filterverbindungsvorrichtung nach Anspruch 6, wobei der erste Verbinder (100) ein Gehäuse (110) und einen Anschlussstift (120), der sich innerhalb des Gehäuses (110) befindet, umfasst, wobei zwei Enden des Gehäuses (110) einen Kabeleinlass (111) bzw. einen mit dem zweiten Verbinder (300) verbundenen Verbindungsabschnitt (112) aufweisen, wobei sich ein Ende des Anschlussstifts (120) innerhalb des Kabeleinlasses (111) befindet, sodass der Anschlussstift (120) und der Kabeleinlass (111) die Kabelverbindungsschnittstelle (101) bilden, und wobei das andere Ende des Anschlussstifts (120) von dem Verbindungsabschnitt (112) vorsteht, um den ersten Verbindungsanschluss (102) zu bilden.

12. Filterverbindungsvorrichtung nach einem der Ansprüche 1 bis 5, wobei der erste Verbinder (100) und der zweite Verbinder (300) unter Verwendung eines Befestigungselements verbunden sind und wobei das Befestigungselement, das den ersten Verbinder (100) und den zweiten Verbinder (300) verbindet, durch die erste Filterplatine (200) geht.

## Revendications

1. Appareil de connexion de filtre, l'appareil de connexion de filtre comprenant un premier connecteur (100), une première carte de filtre (200) et un deuxième connecteur (300) ; et
• le premier connecteur (100) étant connecté au deuxième connecteur (300), le premier connecteur (100) étant doté d'une interface de connexion de câble (101) et d'une première borne de connexion (102) connectée électriquement à la première carte de filtre (200),
• le deuxième connecteur (300) étant doté d'une borne de connexion de carte principale (301) et d'une deuxième borne de connexion (302) connectée électriquement à la première carte de filtre (200),
• la première carte de filtre (200) étant configurée pour filtrer un signal transmis entre le premier connecteur (100) et le deuxième connecteur (300),
• la première carte de filtre (200) étant dotée d'une pluralité de circuits de filtre (210), et chacun de la pluralité de circuits de filtre (210) étant configuré pour filtrer un signal, **caractérisé en ce que**
chaque circuit de filtre (210) comprend au moins un composant de filtrage (207), et la pluralité de circuits de filtre (210) comprennent au moins un type de circuit de filtre (210), deux circuits de filtre (210) de types différents comprennent au moins certains composants de filtrage (207) différents, et des types différents de circuits de filtre (210) sont configurés pour filtrer des types différents de signaux, le composant de filtrage (207) comprenant : une self de choc en mode commun et/ou une perle en ferrite et/ou un condensateur, chaque type de composant de filtrage (207) compris dans le circuit de filtre (210) comprenant un ou plusieurs composants de filtrage, et un mode de connexion du composant de filtrage (207) dans le circuit de filtre (210) comprenant une connexion série et/ou une connexion parallèle.

2. Appareil de connexion de filtre selon la revendication 1, dans lequel une cavité est ménagée entre le premier connecteur (100) et le deuxième connecteur (300), et la première carte de filtre (200) est située à l'intérieur de la cavité.

3. Appareil de connexion de filtre selon la revendication 1, dans lequel le circuit de filtre (210) est configuré pour : filtrer un signal entré par le premier connecteur (100), et filtrer un signal entré par le deuxième connecteur (300).

4. Appareil de connexion de filtre selon la revendication 1, dans lequel la première carte de filtre (200) est au moins une couche de carte de circuit imprimé, et chacune de l'au moins une couche de carte de circuit imprimé est pourvue de certains de la pluralité de circuits de filtre (210).

5. Appareil de connexion de filtre selon la revendication 1, l'appareil de connexion de filtre comprenant en outre au moins une deuxième carte de filtre, l'une quelconque de l'au moins une deuxième carte de filtre étant dotée des mêmes dimensions de montage que celles de la première carte de filtre (200), et un composant de filtrage dans un circuit de filtre sur l'une quelconque de l'au moins une deuxième carte de filtre étant doté d'une spécification différente de celle d'un composant de filtrage (207) dans au moins un des circuits de filtre sur la première carte de filtre (200).

6. Appareil de connexion de filtre selon l'une quelconque des revendications 1 à 5, dans lequel la première carte de filtre (200) est dotée d'une pluralité de paires de prises, la pluralité de paires de prises sont connectées respectivement à la pluralité de circuits de filtre (210), et un circuit de filtre (210) est connecté entre chacune de la pluralité de paires de prises ; et
chaque paire de prises comprend une première prise (201) et une deuxième prise (202), le deuxième connecteur (300) est connecté électriquement à la première prise (201) sur un côté de la première carte de filtre (200), et le premier connecteur (100) est connecté électriquement à la deuxième prise (202) de l'autre côté de la première carte de filtre (200).

7. Appareil de connexion de filtre selon la revendication 6, dans lequel le deuxième connecteur (300) comprend un adaptateur (310) et un couvercle de montage (320) ; et le couvercle de montage (320) est connecté au premier connecteur (100), une extrémité de l'adaptateur (310) est utilisée comme la deuxième borne de connexion (302) et est connectée électriquement à la première carte de filtre (200), et l'autre extrémité de l'adaptateur (310) fait saillie du couvercle de montage (320) et est utilisée comme la borne de connexion de carte principale (301).

8. Appareil de connexion de filtre selon la revendication 7, dans lequel l'adaptateur (310) comprend une pluralité de broches en L (311) agencées en parallèle à intervalles et un bloc de matériau isolant (312), deux extrémités de la broche en L (311) forment respectivement la deuxième broche de connexion (302) et la broche de connexion de carte principale (301), et la pluralité de broches en L (311) traversent toutes le bloc de matériau isolant (312).

9. Appareil de connexion de filtre selon la revendication 8, dans lequel la deuxième borne de connexion (302) est enfichée dans la première prise (201), et une pluralité de premières prises (201) sont en correspondance une à une avec la pluralité de broches en L (311).

10. Appareil de connexion de filtre selon la revendication 7, dans lequel le couvercle de montage (320) est un capot de blindage.

11. Appareil de connexion de filtre selon la revendication 6, dans lequel le premier connecteur (100) comprend un boîtier (110) et une broche (120) située à l'intérieur du boîtier (110), deux extrémités du boîtier (110) sont dotées respectivement d'une entrée de câble (111) et d'une partie de connexion (112) connectée au deuxième connecteur (300), une extrémité de la broche (120) est située à l'intérieur de l'entrée de câble (111), de sorte que la broche (120) et l'entrée de câble (111) forment l'interface de connexion de câble (101), et l'autre extrémité de la broche (120) fait saillie de la partie de connexion (112) pour former la première borne de connexion (102).

12. Appareil de connexion de filtre selon l'une quelconque des revendications 1 à 5, dans lequel le premier connecteur (100) et le deuxième connecteur (300) sont connectés au moyen d'une attache, et l'attache connectant le premier connecteur (100) et le deuxième connecteur (300) traverse la première carte de filtre (200).
